# EUROPEAN PATENT APPLICATION

(11) **EP 2 693 500 A1**
(43) Date of publication of application: **05.02.2014**
(21) Application number: 12762961.6
(22) Date of filing: 23.03.2012
(51) Int. Cl.: H01L 33/60, B32B 15/04, B32B 15/20

(54) **REFLECTIVE SUBSTRATE FOR LIGHT-EMITTING ELEMENT AND METHOD FOR PRODUCING SAME**

(30) Priority: 28.03.2011 JP 2011070802; 30.08.2011 JP 2011187380; 20.01.2012 JP 2012010196
(71) Applicant: FUJI-FILM Corporation, Minato-ku Tokyo 106-8620 (JP)
(72) Inventor: HOTTA Yoshinori, Haibara-gun Shizuoka 421-0396 (JP); HATANAKA Yusuke, Haibara-gun Shizuoka 421-0396 (JP); KAWAGUCHI Junji, Haibara-gun Shizuoka 421-0396 (JP)
(74) Representative: HOFFMANN EITLE
(86) International application number: PCT/JP2012/057492
(87) International publication number: WO 2012/133173

(57) **Abstract**

Provided is a reflective substrate for a light-emitting element comprising an inorganic reflective layer as the photoreflective layer on a valve metal substrate, the inorganic reflective layer of which contains at least one inorganic adhesive selected from the group consisting of aluminum phosphate, aluminum chloride, and sodium silicate and inorganic particles having a refractive index between 1.5 and 1.8 and an average grain size between 0.1 and 5 µm, wherein the reflective substrate for a light-emitting element has a highly photoreflective layer with which voids are retained at a lower temperature and strength of the photoreflective layer and adhesiveness with the substrate are retained without high-temperature sintering.

## Description

### TECHNICAL FIELD

The present invention relates to a light reflective substrate that may be used for a light-emitting device and more specifically a reflective substrate for a light-emitting device that may be used for a light-emitting device such as a light-emitting diode (hereinafter referred to as "LED") and a method for manufacturing the same.

### BACKGROUND ART

It is said that LEDs generally use as little as one-hundredth of the electricity consumed in fluorescent lamps and have a lifetime forty times longer than that of fluorescent lamps (40,000 hours). The characteristics including power saving and longer lifetime are important elements based on which LEDs are adopted in the environment-oriented society.

In particular, white LEDs also have merits including excellent color rendering properties and simpler power circuit than fluorescent lamps and therefore expectations are rising for their use in illumination light sources.

Recently, white LEDs with high luminous efficiency (30 to 150 lm/W) required as the illumination light sources successively appeared on the market and replaces fluorescent lamps (20 to 110 lm/W) in the light use efficiency during practical use.

This sharply accelerated the trend for practical application of white LEDs instead of fluorescent lamps and there are an increasing number of cases where white LEDs are adopted for the backlight and illumination light source in liquid crystal display devices.

A ceramic substrate obtained by sintering a green sheet molded from alumina particles has more excellent insulation properties and heat dissipation properties than organic materials and is hence used as a substrate for a light-emitting device such as an LED. However, the sintered ceramic has low surface light reflectance because of its translucency, and when used as a substrate for mounting an LED device, needs to have a reflective layer made of, for example, "silver" in order to reflect light from the light-emitting device and radiate the reflected light toward above the package.

For example, Patent Literature 1 describes a substrate for surface-mounting LEDs, wherein electrodes composed of copper foil circuits in three or more segments are provided in succession from the substrate surface across the plane for wire bonding an LED device, each of the electrodes positioned in a recess is plated with silver or gold, and the recess has light reflectivity. Silver suffers from its high price and considerable changes of the reflectance over time due to oxidation or sulfurization although it shows high reflectance.

It has been found that high translucency which will reduce the reflectance is caused by the suppression of scattering inside the ceramic due to compactness between particles as a result of sintering, and a technique defining the porosity of a sintered body is disclosed as a method for solving the foregoing problem (Patent Literature 2). It is not defined in this technique that sintering itself is necessary but the reflective layer itself also needs to have strength when used as a light reflector, and it is considered that the mechanical strength is achieved by bonding individual oxide particles together through sintering as described in Examples of Patent Literature 2.

In addition, there is known a method of forming a reflective coating containing silica aerogel or other particles dispersed in a transparent resin matrix on a substrate by spraying (Patent Literature 3).

### CITATION LIST

### PATENT LITERATURE

Patent Literature 1: JP 2006-302979 A
Patent Literature 2: WO 2006/104061
Patent Literature 3: JP 11-29745 A

### SUMMARY OF INVENTION

### TECHNICAL PROBLEMS

As shown in Tables 1 and 2 of Examples, the sintering in Patent Literature 2 requires a high temperature exceeding 1,000°C and hence involves fuel costs and equipment costs.

As for the formation of the reflective coating by spraying or other process as disclosed in Patent Literature 3, it is difficult to maintain the adhesion to the substrate and the material of the substrate is also restricted because the substrate is exposed to high temperatures when sintering is performed.

As for the method of Patent Literature 3, it is also described that the resin is used as a binder. In this case, however, the heat resistance of the light reflective layer itself deteriorates and the light reflective layer also cannot withstand changes over time.

The inventors of the invention have studied the above-described problems and an object of the invention is to provide a reflective substrate for a light-emitting device having a highly light reflective layer capable of obtaining a film strength and adhesion to a substrate while maintaining voids by sintering at a lower temperature without relying on high-temperature sintering.

### SOLUTION TO PROBLEMS

The inventors of the invention have made an intensive study to achieve the foregoing object and as a result found that particles having suitable refractive indices and particle sizes can be bonded together by effectively using aluminum phosphate, aluminum chloride and/or sodium silicate as an inorganic binding agent (binder) with specific inorganic particles, thereby achieving high light reflectance. The invention has been thus completed.

Specifically, the invention provides the following:
(1) A reflective substrate for a light-emitting device comprising: a valve metal substrate; and an inorganic reflective layer formed on at least part of the valve metal substrate, wherein the inorganic reflective layer contains at least one inorganic binder selected from the group consisting of aluminum phosphate, aluminum chloride and sodium silicate, and inorganic particles having a refractive index of at least 1.5 but up to 1.8 and an average particle size of at least 0.1 µm but up to 5 µm.
(2) The reflective substrate for a light-emitting device according to (1), further comprising an anodized film layer between the valve metal substrate and the inorganic reflective layer.
(3) The reflective substrate for a light-emitting device according to (1) or (2), wherein the inorganic particles comprise at least one selected from the group consisting of a metal oxide, a metal hydroxide, a metal carbonate and a metal sulfate.
(4) The reflective substrate for a light-emitting device according to any one of (1) to (3), wherein the inorganic reflective layer is obtained by baking at a low temperature of 100°C to 300°C.
(5) The reflective substrate for a light-emitting device according to any one of (1) to (4), wherein the inorganic particles comprise at least one selected from the group consisting of barium sulfate and aluminum oxide.
(6) The reflective substrate for a light-emitting device according to any one of (1) to (5), wherein the valve metal is at least one metal selected from the group consisting of aluminum, tantalum, niobium, titanium, hafnium, zirconium, zinc, tungsten, bismuth and antimony.
(7) The reflective substrate for a light-emitting device according to any one of (1) to (6), wherein the valve metal substrate has a thickness of 0.1 to 2 mm.
(8) The reflective substrate for a light-emitting device according to any one of (1) to (7), wherein the valve metal is aluminum.
(9) The reflective substrate for a light-emitting device according to any one of (1) to (8), having a tensile strength of 100 MPa or less.
(10) The reflective substrate for a light-emitting device according to any one of (1) to (9), wherein the inorganic particles include two or more types of particles.
(11) The reflective substrate for a light-emitting device according to any one of claims (1) to (10), further comprising a silicon-containing surface coating layer on a surface of the reflective substrate.
(12) The reflective substrate for a light-emitting device according to (11), wherein a contact angle between a water droplet in air and a surface of the surface coating layer is 30 degrees or more.
(13) The reflective substrate for a light-emitting device according to any one of (1) to (12), further comprising a metal interconnect layer on a surface of the reflective substrate.
(14) The reflective substrate for a light-emitting device according to any one of (1) to (13), wherein the valve metal layer has a concave shape and the anodized film layer and the inorganic reflective layer are formed on a surface of the valve metal layer having the concave shape.
(15) A white light-emitting diode unit comprising: the reflective substrate for a light-emitting device according to any one of (1) to (14); a blue light-emitting device provided on the reflective substrate for a light-emitting device; and a fluorescent emitter provided around and/or above the blue light-emitting device.
(16) A method for manufacturing a reflective substrate for a light-emitting device, comprising: applying onto a valve metal substrate an aqueous dispersion containing an inorganic binder precursor for producing at least one inorganic binder selected from the group consisting of aluminum phosphate, aluminum chloride and sodium silicate as a result of reaction through baking at a low temperature and inorganic particles having a refractive index of at least 1.5 but up to 1.8 and an average particle size of at least 0.1 µm but up to 5 µm; and baking the applied aqueous dispersion at a low temperature to form an inorganic reflective layer.
(17) The method for manufacturing a reflective substrate for a light-emitting device according to (16), wherein a surface of at least part of the valve metal substrate is anodized to form an anodized film layer and the inorganic reflective layer is formed on the anodized film layer.
(18) The method for manufacturing a reflective substrate for a light-emitting device according to (16) or (17), wherein the baking at a low temperature is performed at a temperature of 100°C to 300°C.
(19) The method for manufacturing a reflective substrate for a light-emitting device according to any one of (16) to (18), further comprising conducting surface treatment with a silicon-containing treatment solution and drying.
(20) The method for manufacturing a reflective substrate for a light-emitting device according to any one of (16) to (19), wherein a step according to any one of (16) to (19) is followed, in any order, by a step (c) and a step (d):
   the step (c) including forming a metal interconnect layer for transmitting electric signals to the light-emitting device and patterning the metal interconnect layer; and
   the step (d) including subjecting an electrode portion corresponding to a portion where the light-emitting device is to be mounted to processing for forming a metal layer.

### ADVANTAGEOUS EFFECTS OF INVENTION

The invention provides a reflective substrate for a light-emitting device having a highly light reflective layer which maintains voids and has high strength and high adhesion to the substrate without relying on high-temperature sintering.

In the embodiment in which an anodized film layer is further provided between the substrate and the inorganic reflective layer, the adhesion between the inorganic reflective layer and the substrate is high.

### BRIEF DESCRIPTION OF DRAWINGS

[FIG. 1] FIG. 1 is a schematic view illustrating the configuration of a reflective substrate for a light-emitting device according to a preferred embodiment of the invention.
[FIG. 2] FIG. 2 is a schematic view illustrating the reflective substrate for a light-emitting device according to another embodiment of the invention.
[FIG: 3] FIG. 3 is a schematic view illustrating an interconnection pattern used in evaluation.
[FIG. 4] FIG. 4 is an electron micrograph (5,000X) of the cross-section of a light reflective substrate manufactured in Example 2-3.

### DESCRIPTION OF EMBODIMENTS

### [Reflective Substrate for Light-Emitting Device]

The reflective substrate for a light-emitting device according to the invention is one including an inorganic reflective layer on a valve metal substrate, wherein the inorganic reflective layer contains at least one inorganic binder selected from the group consisting of aluminum phosphate, aluminum chloride and sodium silicate, and inorganic particles having a refractive index of at least 1.5 but up to 1.8 and an average particle size of at least 0.1 µm but up to 5 µm.

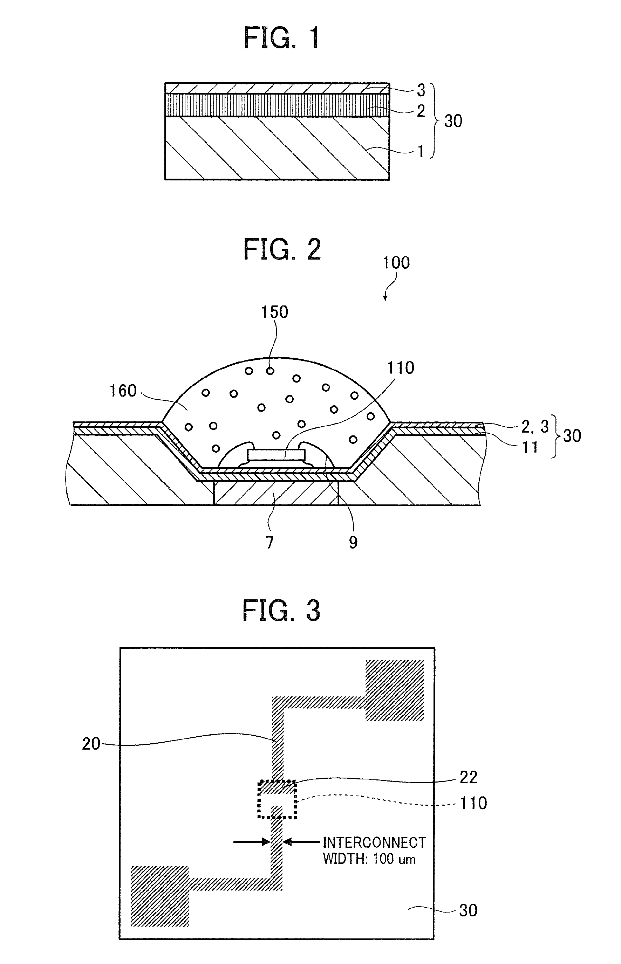

The reflective substrate of the invention is described below with reference to a preferred embodiment shown in FIG. 1.

FIG. 1 shows the embodiment in which an anodized film layer 2 and an inorganic reflective layer 3 are formed on a valve metal substrate 1. The inorganic reflective layer 3 is a layer containing at least one inorganic binder selected from the group consisting of aluminum phosphate, aluminum chloride and sodium silicate, and inorganic particles having a refractive index of at least 1.5 but up to 1.8 and an average particle size of at least 0.1 µm but up to 5 µm. Although the inorganic reflective layer 3 is described as a layer separate from the anodized film layer 2 and is formed as a layer on the anodized film layer 2 for ease of explanation, part of the inorganic reflective layer 3 may penetrate the porous anodized film layer.

Unless otherwise specified, the particle size as used in the specification is denoted by d₅₀, which shows the average particle diameter at 50% in the cumulative particle size distribution. The particle size is measured by, for example, dispersing particles in a liquid and determining the transmittance distribution. The particle size is measured using a laser diffraction particle size analyzer.

FIG. 2 is a cross-sectional view showing another embodiment of the reflective substrate for a light-emitting device according to the invention. In the embodiment of FIG. 2, the valve metal substrate has a concave shape and an anodized film layer 2 and an inorganic reflective layer 3 are formed on a surface of a valve metal substrate 11 having the concave shape. A light-emitting device 110 is mounted on the inorganic reflective layer 3 in its concave portion, and a heat sink 7 for heat dissipation is provided on a surface of the valve metal substrate 11 which is opposite to the surface on which the light-emitting device 110 is mounted via the anodized film layer 2.

Although the following description is made by reference to the example having the anodized film layer 2 and the inorganic reflective layer 3 on the whole surface of the valve metal substrate 1, the reflective substrate for a light-emitting device according to the invention includes the case having no anodized film layer 2. Part of the valve metal substrate 1 may have the anodized film layer 2 and the inorganic reflective layer 3 formed thereon. Alternatively, there may exist portions in which the anodized film layer 2 is only formed on the valve metal substrate 1. The inorganic reflective layer 3 is formed in or on the anodized film layer 2. The inorganic reflective layer 3 may be formed on the whole or part of the anodized film layer 2 because the positions necessary for the inorganic reflective layer and the insulating layer which is the anodized film layer differ depending on the shape of a device to be mounted and the position of the interconnection and these layers are to be arranged in a variety of designs.

### (Inorganic Binder)

The inorganic binder is a material which serves to bond together inorganic particles to be described later through baking at a low temperature to form an inorganic reflective layer. In the practice of the invention, aluminum phosphate, aluminum chloride or sodium silicate is used as the inorganic binder. These may be used as a mixture of two or more thereof.

The inorganic binder can be exemplified specifically as below.

### (Aluminum Phosphate)

Examples of aluminum phosphate include aluminum metaphosphate, aluminum orthophosphate and aluminum polyphosphate.

### (Aluminum Chloride)

Examples of aluminum chloride include aluminum chloride, anhydrous aluminum chloride, aluminum chloride hexahydrate, and polyaluminum chloride (a basic aluminum chloride in polymer form produced by dissolving aluminum hydroxide in hydrochloric acid).

### (Sodium Silicate)

Sodium silicate is also called silicate soda or water glass, and Na₂SiO₃ which is the sodium salt of metasilicic acid is commonly used but in addition to this, use may be made of, for example, Na₄SiO₄, Na₂Si₂O₅ and Na₂Si₄O₉. The sodium salt of metasilicic acid can be obtained by melting silicon dioxide with sodium carbonate or sodium hydroxide.

### (Precursor of Inorganic Binder)

The inorganic binder can be obtained by reacting a precursor of the inorganic binder in the presence of water. Examples of the precursor of the inorganic binder include inorganic acids such as phosphoric acid, hydrochloric acid and sulfuric acid; aluminum, aluminum oxide, aluminum sulfate, aluminum hydroxide, and mixtures thereof. The precursor of the inorganic binder is a substance which may react under baking at a low temperature to produce the inorganic binder. When the reactant is to be neutralized, a sodium hydroxide solution is used. The aluminum compounds may be produced by reacting their starting materials as the inorganic binder precursors. The inorganic binders such as aluminum chloride, aluminum phosphate and sodium silicate may also be used in the form of an aqueous dispersion together with inorganic particles from the beginning. Alternatively, these inorganic binders may be used by mixing with the inorganic binder precursors.

Of those aluminum salts, aluminum hydroxide and aluminum chloride are both preferably added to the aqueous dispersion before baking at a low temperature and the amount of aluminum chloride is preferably from 5 wt% to 10 wt% with respect to the amount of aluminum hydroxide. It is considered that the role of aluminum chloride is to catalytically promote the reaction between aluminum hydroxide and phosphoric acid and aluminum chloride is preferably used in an amount within the above-defined range. In cases where aluminum chloride and hydrochloric acid are used and a precursor of aluminum phosphate is not used, aluminum chloride which is an inorganic binder is not colored and hence the light reflectance is high.

A phosphate compound may be used instead of or together with aluminum phosphate. There is no particular need to limit the phosphate compound as long as it is insoluble in water. Specific examples thereof include magnesium phosphate, calcium phosphate, zinc phosphate, barium phosphate, aluminum phosphate, gallium phosphate, lanthanum phosphate, titanium phosphate and zirconium phosphate. Aluminum phosphate is preferred, and in the case of mixing with other phosphates, aluminum phosphate is preferably used in an amount of at least 50 wt%.

When sodium silicate is used, it is dissolved in water and heated to adjust the viscosity to a value suitable as water glass and used as the inorganic binder precursor.

These inorganic binder precursors can be used by mixing them in any combination so as to produce the inorganic binder to be obtained.

### (Inorganic Particles)

The inorganic particles have a refractive index of at least 1.5 but up to 1.8 and preferably at least 1.55 but up to 1.75. When the refractive index is within the range, the resulting inorganic reflective layer has higher reflectance. This is presumably because of the difference in reflectance from air.

The inorganic particles have an average particle size of at least 0.1 µm but up to 5 µm and preferably 0.5 µm to 2 µm. It is considered that, when the average particle size of the inorganic particles used is within the foregoing range, proper voids can be ensured between particles while achieving the adhesion to the anodized film layer. An average particle size of less than 0.1 µm may deteriorate the reflectance, whereas an average particle size exceeding 6 µm may deteriorate the adhesion to the anodized film layer.

It is necessary to control the sintering process in order to ensure specific voids in the process for bonding inorganic particles together by sintering. In the invention, however, the inorganic reflective layer manufactured using the foregoing inorganic binder can be dried under heating at a low temperature and the inorganic particles are not bonded together by sintering. Accordingly, the average particle size of the inorganic particles for use as the starting material is an important factor.

The inorganic particles are not particularly limited and illustrative examples thereof include:
Aluminum oxide (alumina) (refractive index n = 1.65 - 1.76; numbers in parentheses below being values of the refractive index), aluminum hydroxide (1.58 - 1.65 - 1.76), calcium hydroxide (1.57 - 1.6), calcium carbonate (1.58), calcite (1.61), calcium carbonate (1.61), precipitated calcium carbonate (1.59), heavy calcium carbonate (1.56), ultrafine calcium carbonate (1.57), gypsum (1.55), calcium sulfate (1.59), marble (1.57), barium sulfate (1.64), barium carbonate (1.6), magnesium oxide (1.72), magnesium carbonate (1.52), magnesium hydroxide (1.58), strontium carbonate (1.52), kaolin clay (1.56), calcined clay (1.62), talc (1.57), sericite (1.57), optical glass (1.51 - 1.64) and glass beads (1.51). The material of the particles to be used is not particularly limited as long as it satisfies the refractive index within the above-defined range, and inorganic salts such as metal oxides, metal hydroxides, carbonates and sulfated compounds can be used. Of these, metal oxides are preferably used. This invention does not have a high-temperature sintering step and therefore not only oxides but also various inorganic salts can be used.

As long as the foregoing characteristics are satisfied, two or more types of particles or particles having two or more different average particle sizes may be mixed and used. By combining particles having different particle sizes or particles of different materials, the film strength and the strength of the adhesion to the substrate can be improved.

In addition, the surface smoothening effect can also be expected by the improved coated surface properties.

Furthermore, in the practice of the invention, the shape of the inorganic particles is not particularly limited. The inorganic particles may be, for example, in the shape of a sphere, a polyhedron (e.g., an icosahedron or a dodecahedron), a cube, a tetrahedron, a sphere having surface asperities, a plate or a needle.

Of these, the inorganic particles are preferably in the shape of a sphere, a polyhedron, a cube, a tetrahedron, or a sphere having surface asperities because of excellent thermal insulation properties, and more preferably in the shape of a sphere because of ease of availability and more excellent thermal insulation properties.

### <1. Inorganic Reflective Layer>

The inorganic reflective layer preferably has a dry weight after heating of 20 g/m² to 500 g/m². When the weight is within this range, voids remain in the inorganic reflective layer and therefore the transmission of light is suppressed and the reflectance is high. The use of aluminum phosphate as the binder eliminates the need for sintering and enables formation of the reflective layer at lower cost. The inorganic reflective layer is made of an inorganic material and is also strongly resistant to changes over time. In addition, the inorganic reflective layer is reacted with the anodized film layer on the substrate during the formation of the reflective layer, making it possible to ensure the adhesion to the substrate as well.

The weight of at least one inorganic binder selected from the group consisting of aluminum phosphate, aluminum chloride and sodium silicate is preferably from 5 to 100 parts by weight and more preferably from 10 to 50 parts by weight with respect to 100 parts by weight of the inorganic particles in the inorganic reflective layer.

In addition to the inorganic particles and the inorganic binder, the inorganic reflective layer may contain other compounds. Exemplary other compounds include a dispersant, a reaction accelerator, an inorganic binder precursor (unreacted material), and a reaction product of inorganic particles and an inorganic binder precursor and/or an inorganic binder.

### (Method for Manufacturing Inorganic Reflective Layer)

The method for manufacturing the inorganic reflective layer is not particularly limited, and a preferred method involves mixing inorganic particles into a binder solution containing an inorganic binder precursor to be described later to obtain a mixture, applying the mixture onto the anodized film layer to a predetermined weight using a coater capable of adjusting the coating thickness and then heating (baking at a low temperature).

The coating method is not particularly limited but a variety of methods can be used, as exemplified by bar coating, spin coating, spray coating, curtain coating, dip coating, air knife coating, blade coating and roll coating.

Adjustment of the aqueous dispersion of the inorganic binder precursor and the inorganic particles at a stoichiometric composition ratio based on the reaction formula causes the liquid viscosity to increase rapidly as the reaction proceeds. It is desirable to add a small amount of water in advance in order to avoid such a phenomenon and stably form the inorganic reflective layer. Phosphate ions and hydrochloride ions remaining in the inorganic reflective layer or the anodized film layer may cause corrosion of the substrate and deterioration of an LED sealing material and are therefore not desirable. Therefore, it is desirable to formulate ingredients other than phosphoric acid and hydrochloric acid in slightly excessive amounts with respect to the stoichiometric ratio.

Production of aluminum phosphate, aluminum chloride or sodium silicate in the dried film after heating can be easily confirmed by the analysis of the film surface with an infrared spectrophotometer.

The inorganic reflective layer may also have two or more layers by preparing two or more kinds of binder solutions different in composition and sequentially applying the binder solutions. By combining two or more layers in the inorganic reflective layer, the strength of the inorganic reflective layer and the strength of the adhesion to the substrate can be improved. In addition, the surface smoothening effect can also be expected by the improved coated surface properties.

### (Baking at Low Temperature)

After the aqueous dispersion containing the inorganic binder precursor and the inorganic particles is applied to the substrate, baking at a low temperature is performed in order to allow the reaction to proceed and bond the inorganic particles together by the inorganic binder produced by the reaction.

The temperature in the low temperature baking is from 100°C to 300°C, preferably from 150°C to 300°C and more preferably from 200°C to 250°C.

At a temperature of less than 100°C, water is not appropriately removed and at a temperature exceeding 300°C, changes in strength of the aluminum base occur. Accordingly these temperature ranges are not desirable. In addition, a temperature of 150°C or more is desirable to allow the reaction to proceed between the inorganic binder precursors to bond the inorganic particles together, and a temperature of 180°C or more is more desirable to completely remove adsorption water remaining in the inorganic binder obtained. A prolonged treatment at a temperature exceeding 250°C changes the strength of the valve metal substrate and therefore a treatment at a temperature of 250°C or less is desirable.

The baking time is from 10 minutes to 60 minutes and more preferably from 20 minutes to 40 minutes. A shorter treatment is not sufficient for the reaction to proceed, whereas a longer treatment changes the strength of the valve metal substrate and particularly aluminum metal substrate in relation to the baking temperature. A baking time of 60 minutes or more is not desirable in terms of manufacturing costs. For this reason, the baking time is most preferably from 20 minutes to 40 minutes.

The binder solution contains water and therefore a drying step may be inserted before the low temperature baking treatment performed after coating. The drying step may be performed at a temperature of 100°C or less which does not cause a reaction for producing aluminum phosphate or a bonding reaction.

### <2. Valve Metal Substrate>

Specific examples of the valve metal include aluminum, tantalum, niobium, titanium, hafnium, zirconium, zinc, tungsten, bismuth and antimony.

Of these, aluminum is preferred because it has good dimensional stability and is comparatively inexpensive.

The valve metal substrate may be a single plate.

The valve metal substrate is formed if necessary on another metal plate such as a steel plate, a glass plate, a ceramic plate, a resin plate or other plate.

It is preferred to provide the anodized film layer by anodizing the surface of at least part of the valve metal substrate in order to improve the insulation properties. The anodized film layer on the valve metal substrate is a highly heat-resistant insulating film having an adequate electric resistivity (of about 10¹⁴ Ω·cm).

The valve metal substrate should have a thickness of 10 µm or more in order to form the anodized film and ensure the insulation properties. In cases where another plate material and the valve metal substrate are stacked on each other and used, a laminated plate using a highly heat-resistant, flexible steel plate or metal plate is preferred.

### (Aluminum Plate)

A known type of aluminum plate may be used to manufacture the reflective substrate of the invention. The aluminum plate that may be used in the invention is made of a dimensionally stable metal composed primarily of aluminum; that is, aluminum or aluminum alloy. Plates of pure aluminum, alloy plates composed primarily of aluminum and containing small amounts of other elements may also be used.

In the specification, various substrates made of the above-described aluminum or aluminum alloys are referred to collectively as "aluminum plate." Other elements which may be present in the aluminum alloy include silicon, iron, copper, manganese, magnesium, chromium, zinc, bismuth, nickel and titanium. The content of other elements in the alloy is not more than 10 wt%.

As described above, the aluminum plate that may be used in the invention does not have a specified composition and the purity of aluminum is not particularly limited. Use may be usually made of 1000 series, 3000 series and 5000 series alloys for use as plate materials. When used as a reflective substrate for a light-emitting device, however, the aluminum plate is required to have an excellent withstand voltage and it is desirable to reduce the particles of intermetallic compounds and the like in the material to the lowest possible level. In cases where the reduction of the intermetallic compound particles and the like cannot be avoided by the heat treatment conditions, it is also useful to use aluminum having a purity as high as 99.9% or more.

More specifically, use may be appropriately made of conventionally known materials that appear in the 4th edition of Aluminum Handbook (published in 1990 by the Japan Light Metal Association), such as aluminum plates having the designations JIS A1050, JIS A1100 and JIS A1070, and Mn-containing Al-Mn-based aluminum plates having the designation JIS A3004 and International Alloy Designation 3103A. Al-Mg alloys and Al-Mn-Mg alloys (JIS A3005) composed of the above aluminum alloys to which at least 0.1 wt% of magnesium has been added in order to increase the tensile strength may also be used. Al-Zr alloys and Al-Si alloys which additionally contain zirconium and silicon, respectively may also be used. Use may also be made of Al-Mg-Si alloys.

JIS 1050 materials and JIS 1070 materials are described in paragraphs [0032] to [0033] of WO 2010/150810.

Al-Mg alloys, Al-Mn alloys, Al-Mn-Mg alloys, Al-Zr alloys and Al-Mg-Si alloys are described in paragraphs [0034] to [0038] of WO 2010/150810.

The method for forming an aluminum alloy into a plate shape, the direct chill casting process, the continuous casting process, the crystal structure at the surface of the aluminum plate, and the intermetallic compounds of the aluminum plate are described in paragraphs [0039] to [0050] of WO 2010/150810.

In the practice of the invention, the aluminum plate as described above may also be used by forming asperities on the aluminum plate in the final rolling process or the like through pack rolling, transfer or another method and performing surface roughening treatment thereon. By previously roughening the surface of the substrate, the adhesion between the substrate and the inorganic reflective layer formed on the anodized film layer which in turn is formed on the roughened substrate surface can be improved. The other surface roughening method will be described later.

The aluminum plate that may be used in the invention may be in the form of an aluminum web or a cut sheet.

The valve metal plate that may be used in the invention preferably has a thickness of 0.1 to 2.0 mm. In particular, the aluminum plate has a thickness of about 0.1 to about 2.0 mm, preferably 0.15 to 1.5 mm, and more preferably 0.2 to 1.0 mm. This thickness can be appropriately changed according to the desires of users.

### <3. Surface Roughening Treatment>

The aluminum plate having undergone alkali degreasing in the manufacture of the reflective substrate of the invention may be directly anodized to form the anodized film layer. By anodizing the previously roughened aluminum surface, the adhesion between the anodized film layer and the aluminum plate can be improved. Exemplary surface roughening treatments include a method in which an aluminum plate is subjected to mechanical graining treatment, alkali etching treatment, desmutting treatment with an acid and electrochemical graining treatment with an electrolytic solution in this order; a method in which an aluminum plate is subjected to mechanical graining treatment, and two or more cycles of alkali etching treatment, desmutting treatment with an acid and electrochemical graining treatment (different electrolytic solutions are used in the respective cycles); a method in which an aluminum plate is subjected to alkali etching treatment, desmutting treatment with an acid, and electrochemical graining treatment with an electrolytic solution in this order; and a method in which an aluminum plate is subjected to two or more cycles of alkali etching treatment, desmutting treatment with an acid and electrochemical graining treatment (different electrolytic solutions are used in the respective cycles). However, the invention is not limited thereto. In these methods, electrochemical graining treatment may be further followed by alkali etching treatment and desmutting treatment with an acid.

Although the method applied depends on the conditions of the other treatments (including alkali etching treatment), a method in which mechanical graining treatment, electrochemical graining treatment using a nitric acid-based electrolytic solution, and electrochemical graining treatment using a hydrochloric acid-based electrolytic solution are performed in this order is preferably used to form a surface profile in which the small-wave structure is superimposed on the medium-wave structure, which in turn is superimposed on the large-wave structure. In order to form a surface profile in which the small-wave structure is superimposed on the large-wave structure, a method is preferably used in which electrochemical graining treatment using a hydrochloric acid-based electrolytic solution is only performed with an increased total amount of electricity furnished to the anodic reaction.

The respective surface roughening treatments are described in detail in paragraphs [0055] to [0083] of WO 2010-150810 A.

### <Through-Hole Formation>

In the reflective substrate for a light-emitting device according to the invention, through-hole formation for appropriately providing an interconnection portion and routing processing for a system on a chip assuming a final product (processing for obtaining an individual final product) may also be performed prior to mounting the light-emitting device. Through-hole formation is to perforate at necessary positions. The shape of through-holes to be formed is not particularly limited as long as the through-holes have a length extending over a plurality of layers to be interconnected and have sufficient cross-sectional size and shape to place necessary interconnection. In consideration of the size of a finished chip and reliable interconnection fabrication, the through-holes preferably have a circular shape and a diameter of 0.01 mm to 2 mm, with a diameter of 0.05 mm to 1 mm, especially of 0.1 mm to 0.8 mm, being more preferred.

### (Routing Processing)

Routing processing is an individual cutting process for cutting into a size of a reflective substrate for a light-emitting device (hereinafter referred to as "chip") individualized for a final product or a process for preliminarily forming the plate into a shape facilitating cutting into chips, and is also called patterning or chipping. Routing processing includes forming a slit throughout the thickness of the substrate using a device called a router or forming a slit (a notch) in the thickness direction using a dicer to such an extent that the substrate is not cut.

### <4. Baking Treatment>

It is not preferable for the aluminum plate in the above-described routing processing and through-hole formation to be a flexible substrate having a tensile strength in the tensile test according to JIS Z2241 (rate of pulling: 2 mm/min) (hereinafter referred to as "tensile strength") of 100 MPa or less because such a substrate has unfavorably reduced workability. In manufacturing the reflective substrate for a light-emitting device according to the invention, it is desirable to bake the aluminum plate after mechanical processing including routing processing and through-hole formation to make it more flexible. It is not desirable to perform baking after anodizing treatment because cracks may arise due to the difference in coefficient of thermal expansion between the aluminum and the anodized film. Therefore, it is desirable to perform baking treatment for adjusting the strength of the aluminum plate after mechanical processing but before anodizing treatment. Baking treatment which is performed after mechanical processing but before anodizing treatment preferably involves heating treatment at 250°C to 400°C for 1 to 120 minutes. When baking treatment is performed after anodizing treatment, it is preferred to perform heating treatment at a baking temperature of 200°C to 250°C for 60 to 300 minutes.

### <5. Anodizing Treatment>

The aluminum plate having undergone the above-described surface treatment and processing is further subjected to anodizing treatment. As a result of anodizing treatment, the anodized film layer made of alumina is formed on a surface of the aluminum plate, thereby obtaining a porous or non-porous surface insulation layer.

Anodizing treatment can be carried out by a commonly used method. In this case, an anodized film layer can be formed on the surface of the aluminum plate by passing a current through the aluminum plate as the anode in, for example, an aqueous solution having a sulfuric acid concentration of 50 to 300 g/L and an aluminum concentration of up to 5 wt%. Acids such as sulfuric acid, phosphoric acid, chromic acid, oxalic acid, sulfamic acid, benzenesulfonic acid, amidosulfonic acid, malonic acid, citric acid, tartaric acid and boric acid may be used alone or in combination of two or more thereof for the solution for use in anodizing treatment.

The anodizing treatment conditions vary depending on the electrolytic solution used, and thus cannot be strictly specified. However, it is generally suitable for the solution to have an electrolyte concentration of 1 to 80 wt% and a temperature of 5 to 70°C, for the current density to be 0.5 to 60 A/dm², for the voltage to be 1 to 100 V, and for the electrolysis time to be 15 seconds to 50 minutes. These conditions may be adjusted to obtain the desired anodized film layer weight.

When anodizing treatment is carried out in an electrolytic solution containing sulfuric acid, direct current or alternating current may be applied across the aluminum plate and the counter electrode. When a direct current is applied to the aluminum plate, the current density is preferably 1 to 60 A/dm², and more preferably 5 to 40 A/dm². To keep so-called "burnt deposits" from arising on portions of the aluminum plate due to the concentration of current when anodizing treatment is carried out as a continuous process, it is preferable to apply current at a low density of 5 to 10 A/dm² at the start of anodizing treatment and to increase the current density to 30 to 50 A/dm² or more as anodizing treatment proceeds. When anodizing treatment is carried out as a continuous process, power is preferably fed to the aluminum plate by a solution-mediated power feed system. The solution-mediated power feed system is an indirect power feed system that does not use a conductor roll and feeds power to the aluminum plate through the electrolytic solution.

The anodized film layer may be porous or non-porous. When the anodized film layer is porous, the average pore size is from about 5 to about 1,000 nm and the average pore density is from about 1 x 10⁶ to about 1 x 10¹⁰ pores/mm².

The other details of the anodizing treatment are described in paragraphs [0091] to [0094] of WO 2010/150810.

Aluminum is superior to other metals in having excellent heat dissipation properties because of its very high thermal conductivity. In addition, it is possible to impart the insulation properties to aluminum by forming the anodized film layer as the surface layer.

A plate previously processed into the shape of a substrate on which an LED is to be mounted, for example, a plate formed into a hexagonal or octagonal shape or a plate having through-holes formed therein may be anodized and used as a substrate. Alternatively, anodizing treatment and formation of the above-described inorganic reflective layer may be followed by processing of the plate.

The thickness of the anodized film layer is preferably 1 to 200 µm. A film thickness of less than 1 µm reduces the withstand voltage due to poor insulating properties, whereas a film thickness in excess of 200 µm requires a large amount of electrical power for manufacture, which is economically disadvantageous. The anodized film layer preferably has a thickness of at least 20 µm and more preferably at least 40 µm.

### <6. Sealing Treatment>

In the practice of the invention, the resulting anodized film layer may be sealed according to any known method, illustrative examples of which include boiling water treatment, hot water treatment, steam treatment, sodium silicate treatment, nitrite treatment, and ammonium acetate treatment. Sealing treatment may be carried out by using the apparatuses and methods described in, for example, JP 56-12518 B, JP 4-4194 A, JP 5-202496 A and JP 5-179482 A.

Other exemplary sealing treatments that may be preferably used include a sealing treatment using a sol-gel process as described in paragraphs [0016] to [0035] of JP 6-35174 A.

A possibility was found that the interconnection fabrication properties of the reflective substrate for a light-emitting device according to the invention can be improved by coating the uppermost layer thereof. The voids which exist in the anodized film layer and the inorganic reflective layer are very small. However, when a wet process involved in the interconnection fabrication is performed, the liquid remains inside to pose a risk of reducing the reflectance or insulation properties.

A silicon-containing surface treatment is desirable as a method for forming a compact film on the alumina surface without impairing the reflectance of the substrate itself. The resulting reflective substrate can be coated with silicate glass by immersing it in an aqueous solution containing 1 wt% to 5 wt% of sodium silicate and then drying under heating. That is, it is possible to suppress the penetration of the solution by forming a thin glass layer made of, for example, sodium silicate and the reflection characteristics are not impaired.

### <7. Formation of Inorganic Reflective Layer>

The above-described inorganic reflective layer may be formed only on portions of the substrate requiring light reflection by a variety of printing processes such as screen printing, after the substrate is previously processed so that the substrate can be decomposed into chips or parts each including a plurality of chips. The materials for use in the inorganic reflective layer can be saved by forming the inorganic reflective layer by this method.

### <8. Reflective Substrate for Light-Emitting Device>

In cases where the valve metal plate is used alone and another metal plate is not used as a core material for reinforcement, the above-described reflective substrate for a light-emitting device according to the invention which includes the inorganic reflective layer has a tensile strength according to the tensile test of JIS Z2241 (rate of pulling: 2 mm/min) (hereinafter referred to as "tensile strength") of preferably 100 MPa or less and more preferably 30 to 80 MPa.

### <9. Surface Coating Layer>

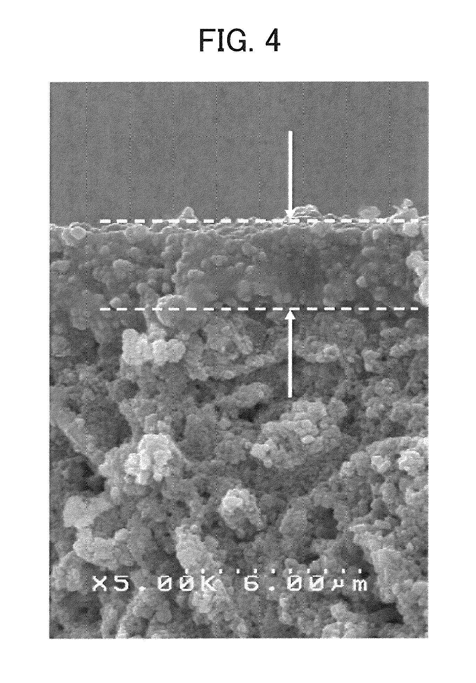

The reflective substrate for a light-emitting device according to the invention may further include a silicon-containing surface coating layer on the inorganic reflective layer 3, as shown in FIG. 4. By forming the inorganic reflective layer 3 and then providing a surface coating layer 4 as the surface layer so as to cover the voids in the inorganic reflective layer, the surface smoothness is increased and the adhesive is prevented from penetrating the inorganic reflective layer upon mounting of an LED chip while ensuring high reflectance of the inorganic reflective layer, whereby useless consumption of the adhesive is avoided and a high adhesion force and excellent die bonding properties are obtained.

The surface coating layer 4 of the invention is formed by surface treatment with a silicon-containing treatment solution. Illustrative examples of the silicon-containing treatment solution include an aqueous sodium silicate solution and a silicone resin. The silicone resin may be diluted with an organic solvent and used. Exemplary surface treatment methods using such a treatment solution include immersion in the treatment solution, application of the treatment solution and spray coating with the treatment solution. Exemplary coating processes include roll coating, curtain coating, spin coating and brush coating. The resulting surface coating layer is a silicate glass coating layer or a silicone resin coating layer.

The surface coating layer can smooth the surface asperities of the inorganic reflective layer, eliminate the surface defects, suppress the penetration of an adhesive for use in the LED chip mounting and reduce the amount of the adhesive. On the other hand, the internal voids in the inorganic reflective layer can be ensured and therefore the light reflectance is not reduced.

The contact angle between a water droplet in air and the surface of the surface coating layer is preferably 30° or more. The contact angle in the specification is a value as measured by the θ/2 method. The contact angle according to the θ/2 method is a value θ obtained by doubling the angle of straight lines connecting the left and right ends and the apex of a droplet with respect to a solid surface.

The contact angle depends on the material and the surface profile of the resulting surface coating layer. In the case of using a silicone resin material, the intermolecular cohesion force is low (about 20 dyne/cm) because of functional groups present on the surface, and the surface coating layer exhibits high water repellency and has a contact angle of about 40° to about 90° with respect to water (about 73 dyne/cm). The surface coating layer of the invention generally contains inorganic particles having strong intermolecular cohesion force and has, as a whole of the material, a lower contact angle than that using a material only composed of silicone resin. That is, the surface coating layer shows a hydrophilic tendency. The material composed of inorganic particles and silicone resin has a contact angle of about 30° to about 70°.

On the other hand, as for the effect of the surface profile, it is said that larger asperities have more effect of enhancing the water repellency. Therefore, higher water repellency is achieved by coating an uneven surface with a water-repellent material. The surface coating layer has a preferable coating weight. The surface coating layer need only have a thickness of 1 µm or more to cover the surface defects such as cracks and pinholes. In relation to the asperities (surface roughness Ra) of the base material, coating to the thickness as defined above reduces the surface roughness Ra of the coating layer and the surface coating layer substantially exhibits water repellency of its material having no enhancement due to the asperities and shows a contact angle of 30° to 50°.

In addition, in the case of using a thick surface coating layer, the surface coating layer itself reflects light and the effect of the inorganic reflective layer cannot be obtained. When the thickness exceeds 10 µm, the light reflectance substantially depends on the characteristics of the surface coating layer itself and a value of less than 90% is only obtained although the light reflectance of the inorganic reflective layer exceeds 90%. The function of the surface coating layer as a light reflector thus degrades. The thickness of the surface coating layer is more preferably from 2 µm to 5 µm.

### <10. Metal Interconnect Layer>

A metal interconnect layer may be further formed in the reflective substrate for a light-emitting device according to the invention. The metal interconnect layer may be provided on the anodized film layer and the inorganic reflective layer on which the light-emitting device is to be mounted, or if necessary on the surface coating layer. As shown in FIG. 3, an electrode portion 22 corresponding to the portion where the light-emitting device is to be mounted may be processed for forming a metal layer to thereby form the electrode portion 22 at the end of the metal interconnect layer. The metal interconnect layer may also be formed on the back side opposite to the anodized film layer on which the light-emitting device is to be mounted, and be electrically connected via a through-hole to the side on which the light-emitting device is to be mounted. In a case where the metal interconnect layer is formed on the inorganic reflective layer having no surface coating layer, the liquid ingredients of the metallic ink penetrate the inorganic reflective layer and therefore this case is excellent in interconnection fabrication.

The material of the metal interconnect layer is not particularly limited as long as it is an electrically conductive material (hereinafter also referred to as "metal material"), and specific examples thereof include gold (Au), silver (Ag), copper (Cu), aluminum (Al), magnesium (Mg) and nickel (Ni). These may be used alone or in combination of two or more thereof. Of these, copper is preferably used because of its low electric resistance. A gold layer or a nickel/gold layer may be formed on top of the copper metal interconnect layer in order to enhance the ease of wire bonding.

The metal interconnect layer may be of a multilayer structure using these materials. For example, an embodiment in which layers are formed in the order of a silver layer, a nickel layer and a gold layer from the lowermost layer is preferable.

The thickness of the metal interconnect layer may be determined as desired depending on the purpose or intended use, but in terms of conduction reliability and packaging compactness, the metal interconnect layer preferably has a thickness of 0.5 to 1,000 µm, more preferably 1 to 500 µm and most preferably 5 to 250 µm.

### <Formation of Metal Interconnect Layer>

An exemplary method for forming the metal interconnect layer includes a method which involves pattern printing on the receptive layer by, for example, inkjet printing or screen printing using metallic ink containing the above-described metal material and liquid ingredients (e.g., a solvent and a resin ingredient).

Such a forming method enables simple formation of the patterned metal interconnect layer on the surface with asperities of the inorganic reflective layer without requiring a lot of steps.

Other exemplary methods of forming the metal interconnect layer include various plating treatments such as electrolytic plating, electroless plating and displacement plating, sputtering, vapor deposition, vacuum application of metal foil and adhesion using an adhesive layer.

The thus formed metal interconnect layer is patterned by any known method according to the light-emitting device mounting design. A metal layer (also including a solder) may be formed again in the portion where the light-emitting device is to be actually mounted, so as to conduct appropriate processing for easier connection by thermocompression bonding, flip-chip bonding or wire bonding.

The suitable metal layer is preferably made of solder or such a metal material as gold (Au), silver (Ag), copper (Cu), aluminum (Al), magnesium (Mg) and nickel (Ni). When the light-emitting device is mounted by heating, a method of applying solder or applying gold or silver through nickel is preferred for the connection reliability.

By forming a pattern on the inorganic reflective layer using metallic ink through inkjet printing or screen printing in the metal interconnect layer-forming method, the patterned metal interconnect layer can be simply formed on the surface with asperities without requiring a large number of steps. The adhesion between the metal interconnect layer and the inorganic reflective layer is also excellent owing to the high anchor effect produced by the asperities of the inorganic reflective layer. By combination with electroless plating or other technique, a metal layer (also including a solder) can be formed again on the metal interconnect layer so as to appropriately process the metal interconnect layer for facilitated interconnection or connection to the electrode by thermocompression bonding, flip-chip bonding or wire bonding.

### <11. White Light Emitting Unit>

FIG. 2 is a schematic view showing an exemplary configuration of the white light emitting unit of the invention.

In the example of FIG. 2, the valve metal substrate has a concave shape and the anodized film layer 2 and the inorganic reflective layer 3 are formed on a surface of the valve metal substrate 11 having the concave shape. The light-emitting device 110 is mounted on the inorganic reflective layer 3 in its concave portion, and the heat sink 7 for heat dissipation is provided on the surface of the valve metal substrate 11 which is opposite to the surface on which the light-emitting device 110 is to be mounted via the anodized film layer 2.

In a white light-emitting unit 100 shown in FIG. 2, an LED device serving as the light-emitting device 110 is mounted on a reflective substrate 30 for a light-emitting device having an electrode for external connection and is electrically connected to the electrode by wire bonding 9. The light-emitting device 110 is sealed with a resin material 160 containing a phosphor (fluorescent particles) 150. In the white light-emitting unit 100, light at a desired wavelength can be obtained by color mixing of light from the LED device and excitation light from the phosphor 150. In the case of use as the white light-emitting unit, an LED device emitting blue light is used as the LED device and the LED device is sealed with resin containing a YAG (yttrium aluminum garnet) or other phosphor (fluorescent particles) 150. Pseudo white light is emitted to the light-emitting surface side by color mixing of blue light from the LED device with excitation light in the yellow region from the phosphor (fluorescent particles) 150.

The LED device which includes a light-emitting layer of a semiconductor such as GaAlN, ZnS, ZnSe, SiC, GaP, GaAlAs, AlN, InN, AlInGaP, InGaN, GaN or AlInGaN can be used. The semiconductor is, for example, of a homostructure, heterostructure or double heterostructure having an MIS junction, PIN junction or PN junction. The light-emitting wavelength may be variously selected in a range of ultraviolet light to infrared light depending on the material of the semiconductor and the mixture ratio thereof.

The white light-emitting unit 100 of the invention includes the reflective substrate 30 in which the anodized film layer 2 and the inorganic reflective layer 3 are formed on the valve metal substrate 11 and have excellent film strength and adhesion to the substrate, and the reflective layer also has high light reflectance.

The LED device is widely used in various fields such as indoor and outdoor lighting, automobile headlights and backlight units in display devices, so that the reflective substrate for a light-emitting device according to the invention which has high light reflection characteristics without sintering at a high temperature is useful.

### EXAMPLES

The present invention is described below more specifically by way of examples. However, the present invention should not be construed as being limited to the following examples.

### <1. Preparation of Coating Solution for Reflective Layer>

Phosphoric acid, aluminum hydroxide and water were mixed to obtain binder solutions and 100 g each of powder particles shown below were added to 100 g each of the binder solutions in various combinations and stirred. The resulting mixtures were applied to prepared seven types of substrates. The substrates were baked at a low temperature of 180°C for 30 minutes.

The binder solutions were formulated as shown below.

**<Binder Solution (1)>**

| | |
|---|---|
| Phosphoric acid 85% | |
| (Wako Pure Chemical Industries, Ltd.) | 48 g |
| Aluminum hydroxide | |
| (Wako Pure Chemical Industries, Ltd.) | 11 g |
| Water | 41 g |
| Total | 100 g |

**<Binder solution (2)>**

| | |
|---|---|
| Phosphoric acid 85% | |
| (Wako Pure Chemical Industries, Ltd.) | 48 g |
| Aluminum hydroxide | |
| (Wako Pure Chemical Industries, Ltd.) | 11 g |
| Aluminum chloride | |
| (Wako Pure Chemical Industries, Ltd.) | 0.8 g |
| Water | 40.2 g |
| Total | 100 g |

**<Binder Solution (3)>**

| | |
|---|---|
| Hydrochloric acid 35% | |
| (Wako Pure Chemical Industries, Ltd.) | 31.7 g |
| Aluminum hydroxide | 7.4 g |
| Water | 60.9 g |
| Total | 100 g |

**<Binder Solution (4)>**

| | |
|---|---|
| Sodium silicate | |
| (No. 3 sodium silicate: Fuji Kagaku CORP.) | 80 g |
| Water | 20 g |
| Total | 100 g |

### <Binder Solutions (5) and (6)>

Polyvinyl alcohol (PVA, The Nippon Synthetic Chemical Industry Co., Ltd.) solution was used for the binder solution (5) and epoxy resin (Nippon Steel Chemical Co., Ltd.) for the binder solution (6).

Inorganic particles shown below were added to the foregoing binder solutions to prepare binder solutions for the inorganic reflective layer.
1) Alumina
   Alumina particles used are as described below.
   <1> - <2> AL-160SG-3 from Showa Denko K.K. (particle size: 0.52 µm; purity: 99.9%) was used. To obtain particles having a smaller average particle size, the above alumina particles were pulverized with zirconia beads using a ball mill and particles having a desired average particle size according to the particle size analyzer were collected and used.
   <3> AL-160SG-3 was not pulverized but directly used.
   <4> A42-2 from Showa Denko K.K. (particle size: 4.7 µm; purity: 99.57%) was used.
   <5> A-12 from Showa Denko K.K. (particle size: 30 µm; purity: 99.64%) was used.
2) Silicon dioxide particles HPS™-1000 from Toagosei Co., Ltd. (purity: ≥ 99.9%; average particle size: 1 µm) were used.
3) Calcium hydroxide CSH from Ube Material Industries, Ltd. (purity: 99.99%; average particle size: 1 µm) was used.
4) Magnesium oxide PUREMAG™ FNM-G from Tateho Chemical Industries Co., Ltd. (purity: ≥ 99.99%; average particle size: 0.5 µm) was used.
5) Yttrium oxide from Shin-Etsu Chemical Co., Ltd. (particulate type; purity: 99.99%; average particle size: 1 µm) was used.
6) Zinc oxide LPZINC-2 from Sakai Chemical Industry Co., Ltd. (purity: 99.9%; average particle size: 2 µm) was used.
7) Titanium oxide TA-100 from Fuji Titanium Industry Co., Ltd. (purity: 98.4%; average particle size: 0.6 µm) was used.
8) Zirconium oxide KZ-0Y-LSF from KCM Corporation Co., Ltd. (purity: 99.9%; average particle size: 0.2 µm) was used.
9) Barium sulfate
   Barium sulfate particles used are as described below.
   <1> BF-1 from Toshin Chemicals Co., Ltd. (purity: 97%; average particle size: 0.05 µm) was used.
   <2> B-30 from Toshin Chemicals Co., Ltd. (purity: 94%; average particle size: 0.3 µm) was used.
   <3> W-1 from Takehara Kagaku Kogyo Co., Ltd. (average particle size: 1.5 µm) was used.
   <4> W-6 from Takehara Kagaku Kogyo Co., Ltd. (average particle size: 5 µm) was used.
   <5> W-10 from Takehara Kagaku Kogyo Co., Ltd. (average particle size: 10 µm) was used.

Comparative Examples 3 and 13 did not use aluminum phosphate but only used particles. Comparative Examples 14 and 15 used polyvinyl alcohol and epoxy resin as binders, respectively.

### <2. Preparation of Substrate>

As for the substrates, an aluminum plate (thickness: 0.8 mm; 1050 material; Nippon Light Metal Co., Ltd.) was used, and the following treatments were performed to prepare Substrates A to C, respectively.
Substrate A ··· The aluminum plate was only subjected to alkali degreasing treatment.
Substrate B ··· The aluminum plate was subjected to alkali degreasing treatment and anodizing treatment.
Substrate C ··· The aluminum plate was subjected to alkali degreasing treatment, surface roughening treatment and anodizing treatment.

In a separate process, aluminum plates (thickness: 0.4 mm and 1.6 mm; 1050 materials; Nippon Light Metal Co., Ltd.) were used, and the following treatments were performed in the same manner to prepare Substrates D to I, respectively. Substrate D ··· The 0.4 mm thick aluminum plate was treated in the same manner as Substrate B.
Substrate E ··· The 0.4 mm thick aluminum plate was treated in the same manner as Substrate C.
Substrate F ··· The 1.6 mm thick aluminum plate was treated in the same manner as Substrate B.
Substrate G ··· The 1.6 mm thick aluminum plate was treated in the same manner as Substrate C.
Substrate H ··· An anodized film with a thickness of 20 µm was formed on a surface of a titanium plate (Soekawa Chemical Co., Ltd.) with a thickness of 0.8 mm to obtain Substrate H. Substrate I ··· An anodized film with a thickness of 20 µm was formed on a surface of a niobium plate (Soekawa Chemical Co., Ltd.) with a thickness of 0.8 mm to obtain Substrate I.

### (1) Treatment Conditions of Substrate A

### a. Degreasing treatment in aqueous alkali solution

The aluminum plate was sprayed with an aqueous solution having a sodium hydroxide concentration of 27 wt%, an aluminum ion concentration of 6.5 wt% and a temperature of 70°C from a spray line for 20 seconds. Then, the solution was removed with nip rollers. Rinsing treatment to be described below was further performed and subsequently water was removed with nip rollers.

Rinsing treatment was carried out by rinsing with a rinsing apparatus that uses a free-falling curtain of water and further by rinsing for 5 seconds with a spray line having a structure in which spray tips discharging fan-like sprays of water are arranged at intervals of 80 mm.

### b. Desmutting treatment in aqueous acid solution

The degreasing treatment was followed by desmutting treatment. The aqueous acid solution for use in desmutting treatment was an aqueous solution having a sulfuric acid concentration of 1 wt% and desmutting treatment was performed by spraying the plate with this solution from a spray line at a solution temperature of 35°C for 5 seconds. Then, the solution was removed with nip rollers. In addition, a spray line of the same structure as that used in the foregoing rinsing treatment was used to perform rinsing treatment and subsequently water was removed with nip rollers.

### (2) Treatment Conditions of Substrate B

Anodizing treatment was performed in an anodizing apparatus using a substrate prepared in the same manner as Substrate A as the anode. Use was made of an electrolytic solution at a temperature of 20°C having an aluminum ion concentration adjusted to 5 g/L by dissolving aluminum sulfate in a 70 g/L aqueous sulfuric acid solution. Constant-voltage electrolysis was performed in anodizing treatment so that the voltage during the anodic reaction of the aluminum plate was 25 V. The anodized film layer was adjusted to have a final thickness of 20 µm.

Then, the solution was removed with nip rollers. In addition, a spray line of the same structure as that used in the foregoing rinsing treatment was used to perform rinsing treatment and subsequently water was removed with nip rollers.

### (3) Treatment Conditions of Substrate C

A substrate prepared in the same manner as Substrate A was subjected to surface roughening treatment under the following conditions and then anodizing treatment was performed using the anodizing apparatus under the same conditions as those of Substrate B.

### a. Surface roughening treatment method

An electrolytic solution having a nitric acid concentration of 1 wt%, an aluminum ion concentration of 5 g/L and a solution temperature of 60°C was used to perform electrochemical graining treatment. Aluminum nitrate was added to adjust the aluminum ion concentration. The ammonium ion concentration was 70 mg/L.

A power supply which controls the current by means of PWM control using an IGBT device and which generates an alternating current having any waveform was used to apply the alternating current across a sample and a carbon counter electrode, thereby performing electrochemical graining treatment.

The alternating current used had a trapezoidal waveform. The frequency was set to 60 Hz, the period of time TP until the current reached a peak from zero to 0.1 seconds, and the ratio between the positive current and the negative current to 0.5. The positive current flowing through the sample was adjusted to a quantity of electricity of 200 C/dm².

Then, the solution was removed with nip rollers. In addition, a spray line of the same structure as that used in the foregoing rinsing treatment was used to perform rinsing treatment and subsequently water was removed with nip rollers.

After the foregoing electrolytic treatment, the aluminum plate was sprayed with an aqueous solution having a sodium hydroxide concentration of 27 wt%, an aluminum ion concentration of 6.5 wt% and a temperature of 70°C from a spray line for 20 seconds.

Then, the solution was removed with nip rollers. In addition, a spray line of the same structure as that used in the foregoing rinsing treatment was used to perform rinsing treatment and subsequently water was removed with nip rollers. The above-described degreasing treatment was further followed by desmutting treatment. The aqueous acid solution for use in desmutting treatment was an aqueous solution having a sulfuric acid concentration of 1 wt% and desmutting treatment was performed by spraying the plate with this solution from a spray line at a solution temperature of 35°C for 5 seconds. Then, the solution was removed with nip rollers. After this treatment, anodizing treatment was performed under the same conditions as those of Substrate B.

### <3. Formation of Reflective Layer on Substrate>

Coating solutions prepared from the binder solutions and the inorganic particle materials shown in Table 1 were applied to the substrates using a coater capable of adjusting the coating thickness. Subsequently, each substrate was placed in the oven heated to a baking temperature shown in Table 1, i.e., 80°C, 180°C or 320°C so as to perform baking for 5 minutes. The dry weight of the inorganic reflective layer was in a range of 20 g/m² to 500 g/m² in all of Examples and Comparative Examples.

The binder solutions prepared above were not used in Comparative Examples 13, 14 and 15. Absence is shown by "no" in Table 1. A polyvinyl alcohol binder and an epoxy resin binder were each used to apply the inorganic particles shown in Table 1 to the anodized film layer, then drying was performed.

The inorganic reflective layer-containing reflective substrates for a light-emitting device in Examples 1, 3, 5 and 8 as shown in Table 1 had a tensile strength in the tensile test according to JIS Z2241 (rate of pulling: 2 mm/min) (hereinafter referred to as "tensile strength") of 30 to 80 MPa.

### <4. Evaluation Method>

In relation to the substrates in Examples and Comparative Examples, the workability, the light reflectance, the strength of the inorganic reflective layer and the adhesion force were measured. The results are shown in Table 2.
(1) Workability: A valve metal substrate was subjected to routing processing into a size of 30 mm x 30 mm (square planar shape) and burrs on the worked surface of the 100th chip was observed by an optical microscope. Criteria between the following adjacent criteria were rated "A" and "C", respectively.
   AA: Burrs with a size of 10 µm or more were not observed at all.
   B: Burrs with an average size of 20 to 50 µm were observed.
   D: Burrs with a size of 100 µm or more were observed.
(2) Light reflectance: The light reflectance was measured using a reflection densitometer CM2600D from Konica Minolta, Inc. The light reflectance is a percentage of reflection color density including specular reflection light to incident light. The total reflectivity (overall average in SPIN mode) at 400 to 700 nm was measured.
(3) Strength of inorganic reflective layer: The degree of scratches under a load of 100 g applied by a scratch tester was visually evaluated as the strength of the inorganic reflective layer. The evaluation criteria are as follows.
   AA: No scratch was seen.
   A: Scratches were seen but the film itself was not scraped off.
   B: Scratches were seen and the film itself was scraped off.
   C: The film was broken upon scratching.
(4) The adhesion force between the inorganic reflective layer and the substrate was evaluated as follows.
   C: The sample was cut into a size of 30 mm x 30 mm (square planar shape) with a press cutter and the inorganic reflective layer came off.
   The substrate having no delamination was dropped on the concrete ground from a height of 3 m and was evaluated based on the following criteria.
   AA: The layer did not come off.
   A: The layer partially came off.
   B: The layer came off.
(5) In addition, after having been subjected to 100 cycles of a heat cycle test, each cycle consisting of elevating and lowering of the temperature in a range of 0°C to 400°C (4 hours/cycle), the sample was evaluated for the strength of the inorganic reflective layer and the adhesion force as above and the evaluation before the heat cycle test was compared with the evaluation after the heat cycle test.

The properties of the manufactured substrates are shown in Table 1 and the evaluation results in Table 2. "Yes" indicates cases where the presence of aluminum phosphate was confirmed and "No" indicates cases where aluminum phosphate did not exist. Unmeasurable cases are indicated by dash "-."

**[Table 1]**

| | Substrate | Binder solution | Presence of Inorganic binder | Inorganic particle material | | Baking temp. | Refractive index | Average particle size | Thickness of substrate |
|---|---|---|---|---|---|---|---|---|---|
| | Type | Type | (IR) | Type | | °C | | *µ*m | mm |
| CE 1 | B | (1) | Yes | Alumina <1> | Oxide | 180 | 1.65 | 0.05 | 0.8 |
| EX 1 | B | (1) | Yes | Alumina <2> | Ditto | Ditto | 1.65 | 0.1 | 0.8 |
| EX 2 | B | (1) | Yes | Alumina <3> | Ditto | Ditto | 1.65 | 0.52 | 0.8 |
| EX 3 | C | (1) | Yes | Alumina <3> | Ditto | Ditto | 1.65 | 0.52 | 0.8 |
| EX 4 | A | (1) | Yes | Alumina <3> | Ditto | Ditto | 1.65 | 0.52 | 0.8 |
| CE 2 | B | Unused | No | Alumina <3> | Ditto | Ditto | 1.65 | 0.52 | 0.8 |
| EX 5 | B | (1) | Yes | Alumina <4> | Ditto | Ditto | 1.65 | 4.7 | 0.8 |
| CE 3 | B | (1) | Yes | Alumina <5> | Ditto | Ditto | 1.65 | 30 | 0.8 |
| CE 4 | B | (1) | Yes | Silicon dioxide | Ditto | Ditto | 1.45 | 1 | 0.8 |
| EX 6 | B | (1) | Yes | Calcium hydroxide | Hydroxide | Ditto | 1.57 | 1 | 0.8 |
| EX 7 | B | (1) | Yes | Magnesium oxide | Oxide | Ditto | 1.72 | 0.5 | 0.8 |
| CE 5 | B | (1) | Yes | Yttrium oxide | Ditto | Ditto | 1.82 | 1 | 0.8 |
| CE 6 | B | (1) | Yes | Zinc oxide | Ditto | Ditto | 1.95 | 2 | 0.8 |
| CE 7 | B | (1) | Yes | Titania (titanium oxide) | Ditto | Ditto | 2.7 | 0.6 | 0.8 |
| CE 8 | B | (1) | Yes | Zirconia (zirconium oxide) | Ditto | Ditto | 2.4 | 0.2 | 0.8 |
| CE 9 | B | (1) | Yes | Barium sulfate <1> | Ditto | Ditto | 1.64 | 0.05 | 0.8 |
| EX 8 | B | (1) | Yes | Barium sulfate <2> | Ditto | Ditto | 1.64 | 0.3 | 0.8 |
| EX 9 | B | (1) | Yes | Barium sulfate <3> | Ditto | Ditto | 1.64 | 1.5 | 0.8 |
| EX 10 | B | (1) | Yes | Barium sulfate <4> | Ditto | Ditto | 1.64 | 5 | 0.8 |
| CE 10 | B | (1) | Yes | Barium sulfate <5> | Ditto | Ditto | 1.64 | 10 | 0.8 |
| EX 11 | c | (1) | Yes | Barium sulfate <3> | Ditto | Ditto | 1.64 | 1.5 | 0.8 |
| EX 12 | C | (1) | Yes | Barium sulfate <3>/ alumina <3> | Inorganic salt/oxide | Ditto | 1.64/1.65 | 1.5/0.5 2 | 0.8 |
| EX 13 | C | (1) | Yes | Calcium hydroxide / alumina <3> | Hydroxide/oxide | Ditto | 1.57/1.65 | 1/0.52 | 0.8 |
| EX 14 | C | (1) | Yes | Alumina <2>/<3> | Oxide | Ditto | 1.65/1.65 | 0.1 /0.5 2 | 0.8 |
| EX 15 | A | (1) | Yes | Barium sulfate <3> | Inorganic salt | Ditto | 1.64 | 1.5 | 0.8 |
| CE 11 | B | Unused | No | Barium sulfate <3> | Ditto | Ditto | 1.64 | 1.5 | 0.8 |
| CE 12 | B | (5) | No (PVA) | Alumina <3> | Oxide | Ditto | 1.65 | 0.52 | 0.8 |
| CE 13 | B | (6) | No (Epoxy) | Alumina <3> | Ditto | Ditto | 1.65 | 0.52 | 0.8 |
| EX 16 | B | (2) | Yes | Barium sulfate <3> | Inorganic salt | Ditto | 1.64 | 1.5 | 0.8 |
| EX 17 | D | (1) | Yes | Alumina <3> | Oxide | Ditto | 1.65 | 0.52 | 0.4 |
| EX 18 | E | (1) | Yes | Barium sulfate <3>/alumina <3> | Inorganic salt/oxide | Ditto | 1.64/1.65 | 1.5/0.5 2 | 0.4 |
| EX 19 | F | (1) | Yes | Barium sulfate <3> | Inorganic salt | Ditto | 1.64 | 1.5 | 1.6 |
| EX 20 | G | (1) | Yes | Alumina <2> | Oxide | Ditto | 1.65 | 0.1 | 1.6 |
| EX 21 | B | (3) | Yes | Alumina <3> | Ditto | 80 | 1.65 | 0.52 | 0.8 |
| EX 22 | B | (3) | Yes | Alumina <3> | Ditto | 320 | 1.65 | 0.52 | 0.8 |
| EX 23 | B | (3) | Yes | Alumina <3> | Ditto | 180 | 1.65 | 0.52 | 0.8 |
| EX 24 | B | (4) | Yes | Alumina <3> | Ditto | 180 | 1.65 | 0.52 | 0.8 |
| EX 25 | H | (1) | Yes | Alumina <3> | Ditto | 180 | 1.65 | 0.52 | 0.8 |
| EX 26 | I | (1) | Yes | Alumina <3> | Ditto | 180 | 1.65 | 0.52 | 0.8 |

**[Table 2]**

| | Workability | Reflectance | Strength of inorganic reflective layer | | Adhesion force | |
|---|---|---|---|---|---|---|
| | | % | Before heat cycle | After heat cycle | Before heat cycle | After heat cycle |
| CE 1 | AA | 84 | B | B | A | A |
| EX 1 | AA | 90 | A | A | A | A |
| EX 2 | AA | 92 | A | A | A | A |
| EX 3 | AA | 92 | A | A | AA | AA |
| EX 4 | AA | 93 | A | A | B | B |
| CE 2 | - | - | C | C | C | C |
| EX 5 | AA | 94 | A | A | A | A |
| CE 3 | AA | 91 | C | C | A | A |
| CE 4 | AA | 78 | A | A | A | A |
| EX 6 | AA | 94 | A | A | A | A |
| EX 7 | AA | 91 | A | A | A | A |
| CE 5 | AA | 88 | A | A | A | A |
| CE 6 | AA | 72 | A | A | A | A |
| CE 7 | AA | 87 | A | A | A | A |
| CE 8 | AA | 82 | A | A | A | A |
| CE 9 | AA | 88 | AA | AA | AA | AA |
| EX 8 | AA | 95 | AA | AA | AA | AA |
| EX 9 | AA | 96 | AA | AA | A | A |
| EX 10 | AA | 94 | A | A | A | A |
| CE 10 | AA | 91 | B | B | B | C |
| EX 11 | AA | 95 | AA | AA | AA | AA |
| EX 12 | AA | 94 | AA | AA | AA | AA |
| EX 13 | AA | 94 | AA | AA | AA | AA |
| EX 14 | AA | 93 | AA | A | AA | A |
| EX 15 | AA | 94 | A | A | B | B |
| CE 11 | - | - | C | C | C | C |
| CE 12 | AA | 90 | A | C | A | C |
| CE 13 | AA | 91 | A | B | A | C |
| EX 16 | AA | 95 | AA | AA | AA | AA |
| EX 17 | AA | 92 | A | A | AA | AA |
| EX 18 | AA | 94 | AA | AA | AA | AA |
| EX 19 | B | 95 | AA | AA | AA | AA |
| EX 20 | B | 90 | A | A | A | A |
| EX 21 | B | 93 | B | B | B | B |
| EX 22 | AA | 90 | A | A | A | A |
| EX 23 | AA | 95 | A | A | A | A |
| EX 24 | AA | 91 | A | A | A | A |
| EX 25 | AA | 92 | A | A | A | A |
| EX 26 | AA | 92 | A | A | A | A |

### <5. Presence or Absence of Silicate Glass Coating A>

The reflective substrates obtained in Examples 2, 3, 8 and 10 included in the above-described Examples were immersed in a 2.5 wt% sodium silicate solution and dried at 180°C for 5 minutes to coat the substrates with silicate glass. Examples 2, 3, 8 and 10 in which coating was not performed were compared with Examples 2-2, 3-2, 8-2 and 10-2 in which coating was performed to visually observe the penetration of dropped water droplets, and it could be confirmed that the coated substrates were more resistant to penetration of water droplets and void portions were filled with silicate glass. It could be further confirmed that the coating did not give rise to changes of reflectance. The results without coating are shown in Table 3 and the results with coating A in Table 4.

### <6. Silicone Resin Coating B>

The liquid formulated as described below was applied to the reflective substrates obtained in Examples 2, 3, 9 and 11 of those examples described above, cured at 120°C for 5 minutes and annealed at 120°C for 90 minutes. The resulting coating was evaluated as Examples 2-3, 3-3, 9-3 and 11-3.

Formulation of silicone resin coating liquid: One hundred parts by weight of titanium oxide (trade name: CR-58; Ishihara Sangyo Kaisha, Ltd.) was added to 100 parts by weight of silicone rubber (trade name: KE-1935A/B; Shin-Etsu Chemical Co., Ltd.) and mixed.

The mixture was diluted with a dilution solvent (butyl acetate) to 60 wt% and the dilution was used as a coating liquid. Coating was performed using a screen printer and the film thickness after annealing treatment was 3.5 µm.

FIG. 4 shows an electron micrograph (5.000X) of the cross-section of the light reflective substrate manufactured in Example 2-3. FIG. 4 reveals that a surface treatment layer scarcely having voids is formed on the inorganic reflective layer having voids.

As a result of visual observation of the penetration of dropped water droplets, it could be confirmed that the coated substrates were more resistant to penetration of water droplets and void portions were filled with silicone resin. It could be further confirmed that the coating did not give rise to changes of reflectance. The results with coating B are shown in Table 4.

The evaluation methods are as follows.

### (6) Measurement of Contact Angle

The contact angle was measured by dropping 1 µL of water droplet on the surface of the reflective substrate and analyzing the image of the droplet on the surface using a measuring instrument CA-X manufactured by Kyowa Interface Science Co., Ltd. The results are shown in Table 4.

### (7) Interconnection Fabrication Properties

An inkjet printer (DMP-2831, FUJIFILM Corporation) was used to jet a dilution of silver nanoparticle ink (XA-436; Fujikura Kasei Co., Ltd.) onto the surface of the reflective substrate having no coating, the reflective substrate having the coating A and the reflective substrate having the coating B according to the pattern of an interconnect 20 shown in FIG. 3 thereby forming an interconnect with an interconnect width of 100 µm. Then, the linearity of the interconnect geometry was observed. The interconnect loses a linear shape when the amount of penetration into the substrate is large. Evaluation was made based on the criteria shown below. The results are shown in Tables 3 and 4.
AA: The interconnect was substantially straight in the observation with an optical microscope, and the metal interconnect layer did not come off when a tape was applied and then peeled off.
A: When a tape was applied and then peeled off, the interconnect was deformed.
B: When a tape was applied and then peeled off, the interconnect came off.

It could be confirmed that the presence of a coating allows the interconnection quality to be improved while maintaining the adhesion of the metal interconnect layer.

### (8) Die Bonding Properties

An LED device was fixed to a portion of the reflective substrate where the LED device was to be mounted using a silicone die-bonding material (trade name: KER-3000; Shin-Etsu Chemical Co., Ltd.). After the same type of LED device was fixed to the surface of each reflective substrate with the same amount of adhesive, the lamination interface between the LED device and the reflective substrate was observed with an ultrasonic test equipment and the adhesion area was evaluated. The adhesion area in the case of material failure caused by peeling of the device from the adhesion portion (case in which the surface exposed by peeling is located in the adhesive and not at the adhesion interface) was taken as 100%.
A: The adhesion area was 100% or more.
B: The adhesion area was at least 90% but less than 100%.

It was confirmed that the LED devices mounted on the reflective substrates of Examples 3, 9, 11, 3-2, 9-2, 11-2, 3-3, 9-3 and 11-3 were turned on.

**[Table 3]**

| Reflective plate | Coating is not formed | | | |
|---|---|---|---|---|
| | Water penetrability | Reflectance | Interconnection fabrication properties | Die bonding properties |
| EX 2 | High | 92% | A | B |
| EX 3 | High | 92% | A | B |
| EX 9 | Very high | 96% | A | B |
| EX 11 | Very high | 95% | A | B |

**[Table 4]**

| Reflective plate | Coating A is formed | | | | |
|---|---|---|---|---|---|
| | Water penetrability | Contact angle (° ) | Reflectance | Interconnection fabrication properties | Die bonding properties |
| EX 2-2 | Low | 35 | 92% | AA | A |
| EX 3-2 | Low | 40 | 92% | AA | A |
| EX 9-2 | Low | 35 | 96% | AA | A |
| EX 11-2 | Low | 30 | 95% | AA | A |

| Reflective plate | Coating B is formed | | | | |
|---|---|---|---|---|---|
| EX 2-3 | Extremely low | 50 | 90% | AA | A |
| EX 3-3 | Extremely low | 60 | 90% | AA | A |
| EX 9-3 | Extremely low | 45 | 92% | AA | A |
| EX 11-3 | Low | 40 | 93% | AA | A |

### (Consideration of Examples and Comparative Examples)

The reflective substrates in Examples have high reflectance and are excellent in the strength of the inorganic reflective layer and also in the adhesion force between the inorganic reflective layer and the anodized layer. In particular, when the refractive index and the average particle size of the inorganic particles for use in the inorganic reflective layer are within proper ranges, the substrates are more highly rated. In the evaluation of the workability, strength of the inorganic reflective layer and the adhesion force, the rating which is allowable in practical use is "B" or a higher level.

Examples 4 and 15 are those having no anodized film.

Comparative Examples 2 and 11 did not use a binder solution and hence did not have an inorganic binder contained in the inorganic reflective layer and therefore could not be evaluated for the workability and the reflectance.

Examples 12, 13, 14 and 18 each used inorganic particles composed of two or more inorganic ingredients or having two or more different average particle sizes and were therefore excellent in both of the inorganic reflective layer strength and adhesion force.

In Example 16, aluminum chloride was added to the binder solution for the reflective layer in an amount of 7 wt% with respect to the amount of aluminum hydroxide and the resulting binder solution was used. Therefore, the time required to form the reflective layer in Example 16 was shorter than that in Example 11.

The comparison between Examples 2, 21 and 22 reveals that the workability, the strength of the inorganic reflective layer and the adhesion force are more excellent when the baking temperature is appropriate.

In Example 23, aluminum hydroxide and hydrochloric acid were used in the binder solution for the reflective layer and aluminum chloride was produced as the inorganic binder by baking at a low temperature. The inorganic reflective layer including inorganic particles bonded together by aluminum chloride has higher light reflectance than the reflective layer having particles bonded together by aluminum phosphate.

In Examples 3 and 11 to 14, the metal plate is subjected to surface roughening treatment and anodizing treatment and therefore the adhesion between the inorganic reflective layer and the metal plate is high.

### REFERENCE SIGNS LIST

- 1, 11: valve metal substrate
- 2: anodized film layer
- 3: inorganic reflective layer
- 7: heat sink
- 9: wire bonding
- 20: interconnect
- 22: electrode portion
- 30: reflective substrate for a light-emitting device
- 100: white light-emitting diode unit
- 110: light-emitting device
- 150: phosphor
- 160: resin material

## Claims

1. A reflective substrate for a light-emitting device comprising: a valve metal substrate; and an inorganic reflective layer formed on at least part of the valve metal substrate, wherein the inorganic reflective layer contains at least one inorganic binder selected from the group consisting of aluminum phosphate, aluminum chloride and sodium silicate, and inorganic particles having a refractive index of at least 1.5 but up to 1.8 and an average particle size of at least 0.1 µm but up to 5 µm.

2. The reflective substrate for a light-emitting device according to claim 1, further comprising an anodized film layer between the valve metal substrate and the inorganic reflective layer.

3. The reflective substrate for a light-emitting device according to claim 1 or 2, wherein the inorganic particles comprise at least one selected from the group consisting of a metal oxide, a metal hydroxide, a metal carbonate and a metal sulfate.

4. The reflective substrate for a light-emitting device according to any one of claims 1 to 3, wherein the inorganic particles comprise at least one selected from the group consisting of barium sulfate and aluminum oxide.

5. The reflective substrate for a light-emitting device according to any one of claims 1 to 4, wherein the valve metal is at least one metal selected from the group consisting of aluminum, tantalum, niobium, titanium, hafnium, zirconium, zinc, tungsten, bismuth and antimony.

6. The reflective substrate for a light-emitting device according to any one of claims 1 to 5, wherein the valve metal substrate has a thickness of 0.1 to 2 mm.

7. The reflective substrate for a light-emitting device according to any one of claims 1 to 6, wherein the valve metal is aluminum.

8. The reflective substrate for a light-emitting device according to any one of claims 1 to 7, having a tensile strength of 100 MPa or less.

9. The reflective substrate for a light-emitting device according to any one of claims 1 to 8, wherein the inorganic particles include two or more types of particles.

10. The reflective substrate for a light-emitting device according to any one of claims 1 to 9, further comprising a silicon-containing surface coating layer on a surface of the reflective substrate.

11. The reflective substrate for a light-emitting device according to claim 10, wherein a contact angle between a water droplet in air and a surface of the surface coating layer is 30 degrees or more.

12. The reflective substrate for a light-emitting device according to any one of claims 1 to 11, further comprising a metal interconnect layer on a surface of the reflective substrate.

13. The reflective substrate for a light-emitting device according to any one of claims 1 to 12, wherein the valve metal substrate has a concave shape and the anodized film layer and the inorganic reflective layer are formed on a surface of the valve metal substrate having the concave shape.

14. A white light-emitting diode unit comprising: the reflective substrate for a light-emitting device according to any one of claims 1 to 13; a blue light-emitting device provided on the reflective substrate for a light-emitting device; and a fluorescent emitter provided around and/or above the blue light-emitting device.

15. A method for manufacturing a reflective substrate for a light-emitting device, comprising: applying onto a valve metal substrate an aqueous dispersion containing an inorganic binder precursor for producing at least one inorganic binder selected from the group consisting of aluminum phosphate, aluminum chloride and sodium silicate as a result of reaction through baking at a low temperature and inorganic particles having a refractive index of at least 1.5 but up to 1.8 and an average particle size of at least 0.1 µm but up to 5 µm; and baking the applied aqueous dispersion at a low temperature to form an inorganic reflective layer.

16. The method for manufacturing a reflective substrate for a light-emitting device according to claim 15, wherein a surface of at least part of the valve metal substrate is anodized to form an anodized film layer and the inorganic reflective layer is formed on the anodized film layer.

17. The method for manufacturing a reflective substrate for a light-emitting device according to claim 15 or 16, wherein the baking at a low temperature is performed at a temperature of 100°C to 300°C.

18. The method for manufacturing a reflective substrate for a light-emitting device according to any one of claims 15 to 17, wherein a surface of the valve metal substrate is further treated with a silicon-containing treatment solution and dried.

19. The method for manufacturing a reflective substrate for a light-emitting device according to any one of claims 15 to 18, wherein a step according to any one of claims 15 to 18 is followed, in any order, by a step (c) and a step (d):
the step (c) including forming a metal interconnect layer for transmitting electric signals to the light-emitting device and patterning the metal interconnect layer; and
the step (d) including subjecting an electrode portion corresponding to a portion where the light-emitting device is to be mounted to processing for forming a metal layer.
